# EUROPÄISCHE PATENTSCHRIFT

(11) **EP 4 127 632 B1**
(45) Veröffentlichungstag und Bekanntmachung des Hinweises auf die Patenterteilung: **25.06.2025**
(21) Anmeldenummer: 21715804.7
(22) Anmeldetag: 23.03.2021
(51) Int. Cl.: G01K 1/143, G01R 1/20, G01R 19/32, H05K 1/02, G01R 1/44, H05K 1/11, H05K 1/18

(54) **VORRICHTUNG ZUR TEMPERATURMESSUNG UND VORRICHTUNG ZUR STROMERMITTLUNG**
DEVICE FOR TEMPERATURE MEASUREMENT AND DEVICE FOR CURRENT DETERMINATION
DISPOSITIF DE MESURE DE TEMPÉRATURE ET DISPOSITIF DE DÉTERMINATION DE COURANT

(30) Priorität: 30.03.2020 DE 102020108690
(43) Veröffentlichungstag der Anmeldung: 08.02.2023
(73) Patentinhaber: SMA Solar Technology AG, 34266 Niestetal (DE)
(72) Erfinder: MUEHLHAUSEN, Felix, 34123 Kassel (DE); BUTTERWECK, Simon, 34298 Helsa (DE)
(86) Internationale Anmeldenummer: PCT/EP2021/057404
(87) Internationale Veröffentlichungsnummer: WO 2021/197921

(56) Entgegenhaltungen:
- EP-A1- 1 435 524
- EP-A1- 3 620 799
- EP-A2- 3 537 129
- DE-A1- 102011 004 174
- US-A1- 2007 093 084

## Beschreibung

### TECHNISCHES GEBIET DER ERFINDUNG

Die Erfindung betrifft eine Vorrichtung zur Temperaturmessung, eine Vorrichtung zur Stromermittlung mit einer Temperaturmessbaugruppe sowie einen elektrischen Leistungswandler mit einer Stromermittlungsbaugruppe.

### STAND DER TECHNIK

Eine präzise Messung einer Temperatur eines Gegenstandes mit einem Temperaturfühler, beispielsweise mit einem temperaturabhängigen Widerstand, erfordert in der Regel einen guten thermischen Kontakt zwischen dem Temperaturfühler und dem zu vermessenden Gegenstand. Dabei kann der Temperaturfühler sowie eine zugehörige Auswerteelektronik auf einer Leiterplatte angeordnet sein, so dass der Temperaturfühler sich im Betrieb zwischen der Leiterplatte und einer Oberfläche des zu vermessenden Gegenstandes befindet. Diese Anordnung bedingt jedoch, dass die Leiterplatte selbst zumindest um die Bauhöhe des Temperaturfühlers von der Oberfläche beabstandet ist.

Für eine präzise Ermittlung elektrischer Ströme, insbesondere hoher Ströme im Bereich einiger Kiloampere, können niederohmige Messwiderstände, sogenannte Shunts verwendet werden. Beispielsweise ist aus der DE 10 2016 010 012 B4 eine Messanordnung zur Messung eines Stroms bekannt, bei der Paare von Spannungsabgriffen eine über ein Widerstandselement abfallende Spannung messen, wobei eine Messschaltung anhand des ohmschen Gesetzes aus der abfallenden Spannung und dem Widerstandswert des Widerstandselement ein Maß für den das Widerstandselement durchfließenden elektrischen Strom ermittelt. Dabei ist der Widerstandswert des Widerstandselements temperaturabhängig, so dass ein Temperatursensor an dem Widerstandselement angeordnet ist und die Messschaltung den zur Bestimmung der Stromstärke verwendeten Widerstandswert in Abhängigkeit von der vom Temperatursensor gemessenen Temperatur anpasst.

Aus der EP 3 620 799 A1 und der EP 1 435 524 A1 sind weitere Vorrichtungen zur Stromermittlung bekannt, bei denen ein Spannungsabfall über ein Widerstandselement gemessen wird, wobei zusätzlich eine Temperaturmessung und eine Kalibrierung der Bestimmung der Stromstärke aus den gemessenen Spannungen in Abhängigkeit von der gemessenen Temperatur vorgesehen sind.

Insbesondere wenn das Widerstandselement aus einem gängigen Material besteht, das eine sehr gute Leitfähigkeit aufweist, beispielsweise Kupfer, dessen spezifischer Widerstand jedoch stark temperaturabhängig ist, muss die Temperatur des Widerstandsmaterials genau dort gemessen werden, wo auch der relevante Spannungsabfall stattfindet. Eine an sich bekannte Anordnung des Temperatursensors auf einer dem Widerstandselement zugewandten Seite einer Leiterplatte ermöglicht zwar eine gute thermische Anbindung an das Widerstandselement, bewirkt jedoch einen Abstand zwischen der Leiterplatte und dem Widerstandselement, der zumindest in der Größenordnung der Bauhöhe des Temperatursensors liegt.

Zusätzlich ist es erstrebenswert, die Verbindungen zwischen den Spannungsabgriffen und der Messschaltung sehr dicht am Widerstandselement anzuordnen, insbesondere um Leiterschleifen zu vermeiden. Leiterschleifen können insbesondere in der Nähe von hohen Strömen aufgrund elektromagnetischer Effekte zu erheblichen Beeinträchtigungen oder Verfälschungen der Messung führen, vor allem wenn die Ströme periodische oder transiente Anteile enthalten.

Um solche Leiterschleifen zu vermeiden, besteht die Möglichkeit, den Temperatursensors auf der dem Widerstandselement abgewandten Seite der Leiterplatte anzuordnen, so dass die Leiterplatte mit den Verbindungen zwischen den Spannungsabgriffen und der Messschaltung möglichst nach an dem Widerstandselement angeordnet werden kann. Dabei ist jedoch der thermische Widerstand zwischen Temperatursensor und Stromschiene erhöht, da der Wärmestrom von dem Widerstandselement zuerst in die Leiterplatte eindringen und diese durchdringen muss.

Eine weitere Möglichkeit wäre, den Temperatursensor auf der Seite des Shunts anzubringen, die der Leiterplatte entgegen gesetzt liegt, siehe nochmals die DE 10 2016 010 012 B4. Dies erfordert jedoch zusätzliche Verbindungen zwischen dem Temperatursensor und der Messschaltung, die außerhalb der Leiterplatte verlaufen und insofern Zusatzaufwand in der Montage sowie Zusatzkosten hervorrufen. Zudem ist für eine ausreichend gute Temperaturmessung ein Anpressdruck des Temperatursensors an die zu vermessende Oberfläche notwendig, der jedoch nicht zu hoch sein darf, um den Temperatursensor nicht zu schädigen.

Aus der DE 10 2011 004 174 A1 ist eine elektrische Verbindungsanordnung bekannt, bei der eine Leiterplatte einen höhenflexiblen Leiterplattenbereich aufweist, in dem ein elektronisches Bauelement angeordnet sein kann. Das Bauelement ist dabei mit einer Funktionseinheit mechanisch verbunden und dadurch in seiner Lage fixiert, wobei die mechanische Verbindung zur Funktionseinheit durch zusätzliche Federelemente zwischen Leiterplatte und Bauelement verbessert werden kann.

### AUFGABE DER ERFINDUNG

Der Erfindung liegt die Aufgabe zugrunde, eine Vorrichtung zur Temperaturmessung bereitzustellen, die einen guten thermischen Kontakt eines Temperatursensors mit der Oberfläche eines zu vermessenden Gegenstandes gewährleistet, sowie eine Vorrichtung zur Stromermittlung aufzuzeigen, bei der ein Spannungsabfall über ein Widerstandselement mit temperaturabhängigem Widerstandswert ungestört gemessen werden kann, wobei der Strom aus dem Spannungsabfall und einem Widerstandswert ermittelt wird, der mittels einer exakten Messung der Temperatur des Widerstandselements angepasst wird.

### LÖSUNG

Die Aufgabe wird durch eine Vorrichtung zur Stromermittlung mit einem Shunt, wie im Anspruch 1 definiert ist, gelöst.

### BESCHREIBUNG DER ERFINDUNG

Eine Vorrichtung zur Temperaturmessung umfasst eine Leiterplatte, eine Auswerteeinheit und einen Temperaturfühler. Die Leiterplatte weist eine Ausfräsung auf, die im Wesentlichen spiralförmig um den Temperaturfühler verläuft, sodass der Temperaturfühler auf einem Leiterplattenplateau angeordnet und parallel zum Normalenvektor der Ebene der Leiterplatte verschiebbar ist. Bei einer Verschiebung des Temperaturfühlers gegenüber der Ebene der Leiterplatte wirkt eine Rückstellkraft zwischen der Leiterplatte und dem Temperaturfühler.

Die Vorrichtung zur Temperaturmessung ist besonders vorteilhaft dazu geeignet, direkt auf einer Oberfläche eines Gegenstandes platziert zu werden, dessen Temperatur durch den Temperaturfühler erfasst werden soll. Der Temperaturfühler kann dazu auf einem Leiterplattenplateau angeordnet sein, dass sich im Zentrum der spiralförmigen Ausfräsung und damit am inneren Ende des durch die Ausfräsung gebildeten verbleibenden Leiterplattenstegs befindet. Bei einem flächenbündigen Platzieren der Leiterplatte auf der Oberfläche des zu messenden Gegenstandes mit dem Temperaturfühler zwischen Leiterplatte und Oberfläche wird das Leiterplattenplateau um die Bauhöhe des Temperaturfühlers aus der Ebene der Leiterplatte herausgedrückt, so dass sowohl die Leiterplatte selbst als auch der Temperaturfühler an der Oberfläche anliegen können. Dies vereinfacht insbesondere die Montage der Vorrichtung zur Temperaturmessung auf der Oberfläche des zu vermessenden Gegenstandes.

Der Temperaturfühler ist bevorzugt durch einen zwischen den Windungen der spiralförmigen Ausfräsung verbleibenden Leiterplattensteg federnd gelagert. Der ebenfalls spiralförmige verbleibende Leiterplattensteg erzeugt eine Federwirkung auf das Leiterplattenplateau und damit auf den Temperaturfühler, wenn das Leiterplattenplateau aus der Ebene der Leiterplatte herausbewegt wird. Dies geschieht insbesondere dann, wenn die Leiterplatte flächig auf der Oberfläche des zu vermessenden Gegenstandes platziert wird und die Ausfräsung, die um den Temperaturfühler herum verläuft, einen Höhenausgleich gewährleistet, so dass der Temperaturfühler parallel zum Normalenvektor der Ebene der Leiterplatte verschoben wird. Dabei kann der Temperaturfühler um einen Federweg verschiebbar sein, der mindestens seine Bauhöhe umfasst.

Die Ausfräsung in der Leiterplatte kann bevorzugt entlang einer stetigen Spiralform verlaufen. Dabei kann die Spiralform eine Mehrzahl im wesentlichen gerader Abschnitte und Richtungsänderungen zwischen den Abschnitten umfassen, wobei die Richtungsänderungen insbesondere einen im wesentlichen rechten Winkel zwischen den Abschnitten bewirken; dabei können die Richtungsänderungen selbst stetig sein, also beispielsweise einen Viertelkreis aufweisen. Insbesondere eine stetige Spiralform ist besonders einfach in einem Zuge herstellbar und weist eine gut reproduzierbare Rückstellkraft bei einer Verschiebung des Leiterplattenplateaus aus der Leiterplattenebene heraus auf.

Die Ausfräsung kann derart ausgestaltet sein, dass ein Radiusvektor der Trajektorie der Ausfräsung einen Winkel von mindestens 600 Grad, bevorzugt von mindestens 700 Grad überstreicht, so dass der verbleibende Leiterplattensteg den Temperaturfühler zu mindestens dreiviertel, bevorzugt mindestens einmal umläuft. Dadurch führt eine Verschiebung des Leiterplattenplateaus um die Bauhöhe des Temperaturfühlers aus der Leiterplattenebene heraus zu einer elastischen Verformung des verbleibenden Leiterplattenstegs, die sicher unterhalb einer Grenze zur plastischen Verformung des Leiterplattenmaterials liegt, so dass eine Rückstellkraft des Leiterplattenstegs dauerhaft erhalten bleibt und selbst unter Einflüssen von Temperaturen über 100 Grad Celsius nicht wesentlich vermindert wird.

Bei einer Gestaltung mit geraden Abschnitten kann die Anzahl gerader Abschnitte so gewählt werden, dass die Summe der Winkel der Richtungsänderungen zwischen den geraden Abschnitten die vorgenannten Gradzahlen erreicht. So sind beispielsweise im Fall rechtwinkliger Richtungsänderungen mehr als sechs Abschnitte vorzusehen.

In einer Ausführungsform der Vorrichtung können die Breite des Leiterplattenstegs, die Breite der Ausfräsung und die Länge der Ausfräsung derart ausgelegt sein, dass die Rückstellkraft zwischen der Leiterplatte und dem Temperaturfühler zwischen 0,1 und 10 Newton, bevorzugt zwischen 1 und 5 Newton beträgt, wenn der Temperaturfühler um seine Bauhöhe parallel zum Normalenvektor der Ebene der Leiterplatte verschoben ist. Dadurch wirkt bei flächiger Auflage der Leiterplatte und des Temperaturfühlers auf der Oberfläche des zu vermessenden Gegenstandes eine Kraft auf den Temperaturfühler, die einen sicheren thermischen Kontakt des Temperaturfühlers mit der Oberfläche gewährleistet. Konkret kann die Leiterplatte eine Dicke zwischen 0,5 und 3 Millimeter aufweisen, während die Ausfräsung und der verbleibende Leiterplattensteg jeweils eine Breite zwischen 0,3 und 3 Millimeter aufweisen können.

In einer vorteilhaften Ausführungsform schließt der äußere Rand der Ausfräsung eine Fläche ein, die kleiner als 200 Quadratmillimeter, bevorzugt kleiner als 100 Quadratmillimeter ist. Dadurch kann ein Temperaturfühler mit einem kleinen Gehäuse verwendet werden, der im Wesentlichen die gesamte Fläche des Leiterplattenplateaus einnimmt, wobei etwaige Peripherie-Komponenten auf der Leiterplatte sehr nah an dem Temperaturfühler angeordnet werden können, insbesondere auch auf der dem Temperaturfühler abgewandten Seite des Leiterplattenniveaus.

Zur Kontaktierung des Temperaturfühlers mit einer Auswerteeinheit können elektrische Leiterbahnen entlang des verbleibenden Leiterplattenstegs verlaufen. Dabei können die Leiterbahnen eine Breite zwischen 50 und 1000 Mikrometer aufweisen und zwischen 50 und 1000 Mikrometer untereinander beabstandet sein. Insbesondere kann dadurch auf eine externe Kontaktierung des Temperaturfühlers über Drähte, Kabel oder ähnliches verzichtet werden.

Der Temperaturfühler kann als passives Bauteil ausgeführt sein, das über mindestens zwei Leiterbahnen mit der Auswerteeinheit verbunden ist. Alternativ kann der Temperaturfühler als aktives Bauteil ausgelegt sein und über mindestens drei Leiterbahnen mit der Auswerteeinheit verbunden sein.

In einer Ausführungsform der Vorrichtung kann der Temperaturfühler auf einer ersten Leiterplattenseite und die Auswerteeinheit auf einer zweiten Leiterplattenseite angeordnet sein, so dass die Auswerteeinheit auf der dem Temperaturfühler gegenüber liegenden Seite der Leiterplatte angeordnet ist. Insbesondere kann die erste Leiterplattenseite im Wesentlichen ausschließlich den Temperaturfühler aufweisen, während alle anderen Bauteile auf der zweiten, dem Temperaturfühler gegenüber liegenden Seite angeordnet sind. Dadurch wird besonders vorteilhaft ermöglicht, dass die erste Leiterplattenseite mit dem federnd gelagerten Temperaturfühler flächenbündig auf der Oberfläche des zu vermessenden Gegenstandes aufliegt. Die Leiterbahnen zwischen Temperaturfühler und Auswerteeinheit können hierbei Durchkontaktierungen durch die Leiterplatte aufweisen.

In einer alternativen Ausführungsform können der Temperaturfühler und die Auswerteeinheit auf derselben Leiterplattenseite angeordnet sein. Dadurch kann eine thermische Verbindung zwischen der Unterseite des Temperaturfühlers und der Oberfläche des zu vermessenden Gegenstandes über die Leiterplatte hergestellt werden, wobei die Leiterplatte an der Stelle des Temperaturfühler hinsichtlich der thermischen Leitfähigkeit optimiert sein kann.

Eine Vorrichtung zur Stromermittlung umfasst einen Shunt und eine Vorrichtung zur Temperaturmessung gemäß der vorangehenden Beschreibung. Der Shunt weist zwei Anschlussbereiche sowie einen elektrisch zwischen den Anschlussbereichen liegenden Widerstandsbereich mit einer im Wesentlichen ebenen Oberfläche auf. Die Vorrichtung zur Stromermittlung ist derart im Widerstandsbereich auf der Oberfläche des Shunt angeordnet, dass der Temperaturfühler in thermischer Verbindung mit dem Widerstandsbereich des Shunt angeordnet ist. Dabei sind beiderseits des Temperaturfühlers Spannungsabgriffe angeordnet, die die Oberfläche des Shunt elektrisch kontaktieren, um eine Potentialdifferenz entlang des Widerstandsbereichs zu erfassen.

In einer Ausführungsform der Vorrichtung liegt die Leiterplatte flächig auf dem Shunt auf, so dass die Spannungsabgriffe elektrisch mit der Oberfläche des Shunt kontaktiert sind und der Temperaturfühler auf der Oberfläche des Shunt aufliegt. Dabei ist der Temperaturfühler im montierten Zustand der Vorrichtung gegenüber der Ebene der Leiterplatte um seine Bauhöhe verschoben, so dass der verbleibende Leiterplattensteg eine Rückstellkraft auf das Leiterplattenplateau und damit eine Anpresskraft auf den Temperaturfühler ausübt. Mit dieser Ausführungsform sind die wesentlichen Anforderungen an die Vorrichtung zur Stromermittlung optimal erfüllt, indem der Temperatursensor direkt auf dem Widerstandsbereich platziert und durch die Federwirkung des verbleibenden Leiterplattenstegs optimal thermisch an das Widerstandsmaterial angebunden ist, so dass eine Temperaturmessung mit hoher Genauigkeit erreicht werden kann. Zusätzlich kann der Temperatursensor mittig des Widerstandsbereichs und mittig zwischen den Spannungsabgriffen platziert werden, so dass die Temperatur in genau jenem Bereich gemessen wird, in dem auch der Spannungsabfall aufgrund eines den Shunt durchfließenden Stroms gemessen wird. Dadurch können temperaturbedingte Änderungen des Widerstandes des Materials im Widerstandsbereich des Shunt im Rahmen einer Ermittlung des den Shunt durchfließenden Stroms optimal kompensiert werden. Gleichzeitig liegt die Leiterplatte weitgehend distanzfrei auf der Oberfläche des Widerstandsbereichs auf, so dass die Leiterbahnen in der Leiterplatte, die die Spannungsabgriffe mit einer Messschaltung zur Ermittlung der zwischen den Spannungsabgriffen abfallenden Spannung verbinden, ebenfalls eng an der Oberfläche des Widerstandsbereichs anliegen und Leiterschleifen bei der Spannungsmessung weitgehend vermieden werden.

In einer alternativen Ausführungsform der Vorrichtung sind der Temperaturfühler und die Auswerteeinheit auf der dem Shunt gegenüberliegenden Seite der Leiterplatte angeordnet. Dabei ist das Leiterplattenplateau mechanisch mit der Oberfläche des Shunt verbunden, wobei das Leiterplattenplateau gegenüber der Ebene der Leiterplatte verschiebbar ist. Insbesondere kann die dem Temperaturfühler gegenüberliegende Seite des Leiterplattenplateaus mit dem Shunt verbunden sein, insbesondere mittels eines Klebstoffs. Dabei wird ein etwaiger Versatz zwischen der Ebene der Leiterplatte und der Oberfläche des Shunts an der Stelle des Leiterplattenplateaus ausgeglichen, indem das Leiterplattenplateau und damit der Temperaturfühler um den Versatz gegenüber ihrer Ruheposition in der Leiterplatteneben verschoben wird. Auch diese Ausführungsform erfüllt die Anforderungen an die Vorrichtung zur Stromermittlung optimal, da der Temperaturfühler insbesondere mit seiner Unterseite über das Leiterplattenplateau optimal thermisch an das Widerstandsmaterial angebunden ist und dies auch bleibt, selbst wenn sich die Position der Leiterplatte gegenüber der Oberfläche des Shunt ändern sollte.

Die thermische Verbindung der Unterseite des Temperatursensors kann weiter verbessert werden, indem das Leiterplattenplateau einen Wärmeleiter aufweist, beispielsweise eine metallische Einlage oder mehrere zumindest teilweise miteinander verbundene Kupferlagen. Ausgehend von einer möglichst flächenbündigen Anordnung der Leiterplatte auf dem Shunt kann insbesondere durch thermische und elektromechanische Effekte, die bei hohen Betriebsströmen auf den Shunt wirken, eine Verformung des Shunts und/oder der Leiterplatte entstehen, die zu einem zumindest partiellen Abheben der Leiterplatte vom Shunt führt. Dies wirkt sich dann nicht auf die thermische Anbindung des Temperatursensors an den Shunt aus, da das Leiterplattenplateau mit dem Shunt mechanisch fest verbunden ist und den Versatz zwischen der Ebene der Leiterplatte und der Oberfläche des Shunts ausgleicht.

Konkret können die Spannungsabgriffe symmetrisch um den Temperaturfühler angeordnet und wahlweise als Einpressstifte in der Leiterplatte und/oder im Shunt, als Federkontakte, als Lötverbindungen oder als Schraubverbindungen mit dem Shunt ausgeführt sein.

In einer Ausführungsform kann der Shunt für die Durchleitung von Strömen ausgelegt sein, deren Stromstärke mehr als 100 Ampere, bevorzugt mehr als 1000 Ampere beträgt. Dabei kann der Shunt einstückig aus einem Material ausgebildet sein, wobei der Widerstandsbereich im Wesentlichen durch eine Verjüngung des Querschnitts gegenüber dem Querschnitt der Anschlussbereiche des Shunt gebildet wird. Dadurch werden Materialübergänge vermieden und der Herstellungs- und Montageaufwand verringert.

Alternativ kann der Widerstandsbereich des Shunt aus einem anderen Material als die Anschlussbereiche ausgeführt sein, beispielsweise aus einem Material mit abweichenden elektrischen Eigenschaften, und optional eine Verjüngung des Querschnitts des Shunts umfassen. Dabei kann eine weiter verbesserte Genauigkeit der Stromermittlung erzielt werden, indem die elektrischen Eigenschaften des Materials im Widerstandsbereich genauer bekannt sind als diejenigen des Materials der Anschlussbereiche, insbesondere hinsichtlich der Temperaturabhängigkeit des spezifischen Widerstandes des Materials im Widerstandsbereichs. Dabei ist es nicht zwingend notwendig, im Widerstandsbereich des Shunt ein Material mit besonders geringer Temperaturabhängigkeit des spezifischen Widerstands einzusetzen; vielmehr reicht es aus, die Temperaturabhängigkeit möglichst exakt und reproduzierbar zu kennen und/oder zu ermitteln.

In einer Ausführungsform kann die Verjüngung des Querschnitts des Shunts im Widerstandsbereich eine Reduzierung des Querschnitts auf einen Wert zwischen 10 und 60 Prozent des Querschnitts der Anschlussbereiche des Shunt umfassen. Dadurch wird eine höhere Stromdichte im Widerstandsbereich als in den Anschlussbereichen des Shunt erzielt, die wiederum einen höheren Spannungsabfall bei einem gegebenen durch den Shunt fließenden Strom bewirkt. Diese lokal erhöhte Stromdichte geht zwar mit einer erhöhten Temperatur im Widerstandsbereich einher; dieser Effekt wird jedoch durch die Temperaturkompensation anhand der für den Widerstandsbereich repräsentativen Temperaturmessung neutralisiert und durch eine Eingrenzung auf einen lokal begrenzten und gut definierten Messbereich überkompensiert.

Zur Vermeidung eines gegebenenfalls unerwünschten elektrischen Kontakts kann zwischen dem Temperaturfühler und der Oberfläche des Shunt eine elektrisch isolierende Folie angeordnet sein.

Ein Leistungswandler weist stromführende Leitungen zum Leiten der vom Leistungswandler verarbeiteten Gleich- und/oder Wechselströme auf. Mindestens eine der stromführenden Leitungen umfasst eine Vorrichtung zur Stromermittlung gemäß der vorangehenden Beschreibung, wobei die Vorrichtung eine Unterbrechung der stromführenden Leitungen überbrückt oder in die stromführenden Leitungen integriert ist. Der Leistungswandler ist dazu eingerichtet, aus einer mittels der Spannungsabgriffe erfassten Potentialdifferenz entlang des Widerstandsbereichs des Shunt und einem Widerstandswert des Widerstandsbereichs einen im Betrieb des Leistungswandlers durch die stromführenden Leitungen fließenden Strom zu ermitteln, wobei der zur entsprechenden Berechnung der Stromstärke verwendete Widerstandswert eine Funktion der vom Temperaturfühler erfassten Temperatur ist.

In einer bevorzugten Ausführungsform ist der Leistungswandler auf eine Nennleistung ausgelegt, die größer als 10 kW, bevorzugt größer als 100 kW, besonders bevorzugt größer als 1000 kW ist. In diesen Leistungsklassen ist eine Ermittlung der vom Leistungswandler verarbeiteten Gleich- und/oder Wechselströme aufgrund ihrer entsprechend hohen Amplituden besonders anspruchsvoll und kann mit der beschriebenen Vorrichtung zur Stromermittlung besonders genau durchgeführt werden, wobei die beschriebene Vorrichtung zur Stromermittlung besonders einfach in den Aufbau des Leistungswandler integriert werden kann.

### KURZBESCHREIBUNG DER FIGUREN

Im Folgenden wird die Erfindung anhand in den Figuren dargestellter Ausführungsbeispiele weiter erläutert und beschrieben.
- Fig. 1: zeigt eine Vorrichtung zur Temperaturmessung,
- Fig. 2: zeigt eine Vorrichtung zur Stromermittlung,
- Fig. 3: zeigt einen Querschnitt durch eine Ausführungsform der Vorrichtung zur Stromermittlung, und
- Fig. 4: zeigt einen Querschnitt durch eine weitere Ausführungsform der Vorrichtung zur Stromermittlung.

### FIGUREN BESCHREIBUNG

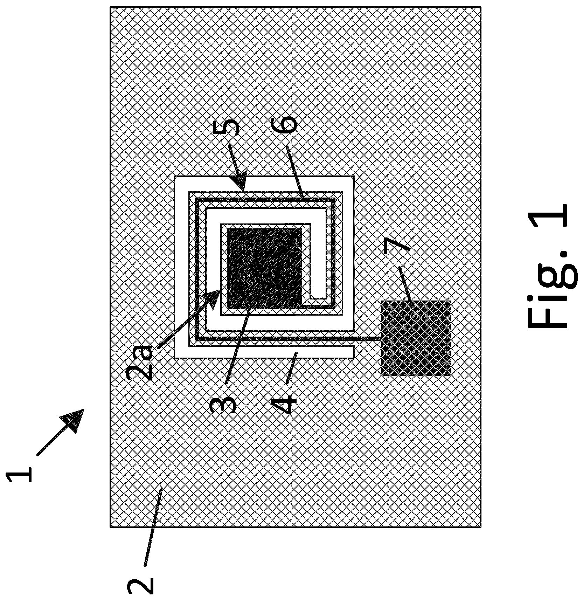

Fig. 1 zeigt eine Temperaturmessbaugruppe 1 als Ausführungsform einer anmeldungsgemäßen Vorrichtung zur Temperaturmessung. Die Temperaturmessbaugruppe 1 umfasst eine Leiterplatte 2. Auf der Leiterplatte 2 ist ein Temperaturfühler 3 angeordnet. Um den Temperaturfühler 3 herum verläuft eine Ausfräsung 4 in der Leiterplatte 2. Die Ausfräsung 4 kann vor der Bestückung der Leiterplatte 2 oder nachträglich nach der Bestückung in die Leiterplatte 2 eingebracht worden sein. Die Ausfräsung 4 verläuft im Wesentlichen spiralförmig um den Temperaturfühler 3 herum, so dass ein Leiterplattensteg 5 verbleibt, der an beiden Seiten von der Ausfräsung 4 begrenzt wird und ebenfalls im Wesentlichen spiralförmig verläuft.

Die Spiralform, entlang der die Ausfräsung 4 verläuft, kann dabei unterschiedlich ausgeführt werden; insbesondere kann sie im Wesentlichen gerade Abschnitte und im Wesentlichen rechtwinklige Richtungsänderungen aufweisen (vergl. Fig. 1), oder sie kann aus Bogensegmenten mit unterschiedlichen Radien zusammengesetzt sein. Ebenso ist denkbar, nicht rechtwinklige Richtungsänderungen vorzusehen. Es versteht sich, dass aus fertigungstechnischen Gründen bei der Ausfräsung einer Richtungsänderung stets gewisse Mindestradien unvermeidbar sind. Daher umfasst eine Richtungsänderung in der Regel einen Bogen, bei einer 90 Grad Biegung kann dies insbesondere ein Viertelkreis sein. Damit kann die Ausfräsung 4 kostengünstig in einem Zug und insbesondere mit einem Standardwerkzeug selbst hergestellt werden.

Am Ende des verbleibenden Leiterplattenstegs 5 befindet sich ein Leiterplattenplateau 2a, auf dem der Temperaturfühler 3 angeordnet ist. Das Leiterplattenplateau 2a ist vollständig von der Ausfräsung 4 umgeben. Zusätzlich verläuft der verbleibende Leiterplattensteg 5 einmal um das Leiterplattenplateau 2a herum. Ein Radiusvektor der Trajektorie der Ausfräsung 4, d.h. ein Vektor von der Mitte des Leiterplattenplateaus 2a zu einem Punkt der Ausfräsung 4, läuft dabei annähernd zwei Mal um den Temperaturfühler 3 herum, d.h. er überstreicht vom Anfang bis zum Ende der Ausfräsung 4 gemäß Fig. 1 einen Winkel von etwa 700 Grad. In alternativen Ausführungsformen kann die Ausfräsung 4 auch kürzer sein und den Temperaturfühler 3 beispielsweise nur eineinhalb Mal oder eindreiviertel Mal umlaufen, entsprechend einem Winkel von etwa 500 Grad bzw. 600 Grad.

Die Temperaturmessbaugruppe 1 weist weiterhin eine Auswerteeinheit 7 auf. Die Auswerteeinheit 7 kann auf derselben Seite der Leiterplatte 2 wie der Temperaturfühler 3 oder auf der gegenüberliegenden Seite angeordnet sein. Der Temperaturfühler 3 ist über Leiterbahnen 6 mit der Auswerteeinheit 7 verbunden. Die Leiterbahnen 6 verlaufen dabei entlang des verbleibenden Leiterplattenstegs 5.

Der Temperaturfühler 3 kann als aktives oder als passives Bauteil ausgeführt sein. Ein aktiver Temperaturfühler 3 muss in der Regel über mindestens drei Leitungen mit der Auswerteeinheit 7 verbunden werden, während ein passiver Temperaturfühler 3 über zwei bis vier Leitungen mit der Auswerteeinheit 7 verbunden ist. Entsprechend umfassen die Leiterbahnen 6 eine geeignete Anzahl einzelner Leitungen, die nebeneinander oder auch übereinander im verbleibenden Leiterplattensteg 5 verlaufen. Bei Verwendung eines aktiven Bauteils als Temperaturfühler 3 kann die Auswerteeinheit 7 auch außerhalb der Leiterplatte 2 angeordnet sein, z.B. auf einer anderen Baugruppe, so dass der Temperaturfühler 3 über die Leiterbahnen 5 und eine weitere Verkabelung mit einer geeigneten programmierbaren Logik oder einem Microcontroller verbunden sein kann.

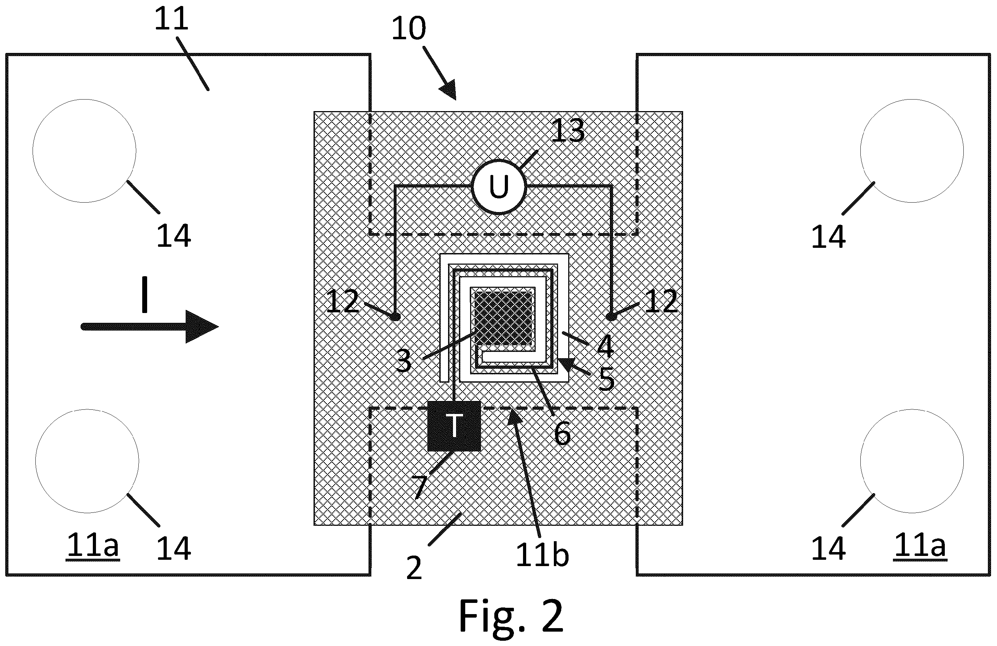

**Fig. 2** zeigt eine Vorrichtung zur Stromermittlung mit einer Stromermittlungsbaugruppe 10 und einem Shunt 11. Der Shunt 11 ist in diesem Beispiel einstückig ausgebildet und umfasst Anschlussbereiche 11a und einen Widerstandsbereich 11b. Die Anschlussbereiche 11a sind hier zur Verbindung mit einer Stromschiene ausgelegt, die beispielsweise Teil eines Leistungswandlers ist und hohe Gleichströme oder Wechselströme transportiert. Dazu kann der Shunt 11 eine Unterbrechung der Stromschiene überbrücken oder auch selbst die Stromschiene bilden, beispielsweise indem an einem Ende des Shunts 11 ein Eingangsanschluss oder eine Halbleiterschaltung des Leistungswandlers und/oder am anderen Ende des Shunts 11 eine Induktivität oder ein Relais anschließbar ist. Alternativ oder zusätzlich können die Anschlussbereiche 11a zur Verbindung mit anders gearteten stromführenden Leitungen, z.B. Kabeln ausgebildet sein, und Verbindungselemente 14 zur elektrischen und/oder mechanischen Verbindung mit angrenzenden Bauteilen aufweisen. Grundsätzlich kann der Widerstandsbereich 11b auch derart in eine stromführende Leitung integriert sein, dass die Anschlussbereiche 11a lediglich die elektrischen Kontaktierungen des Widerstandsbereichs 11b mit angrenzenden Bauteilen bezeichnen.

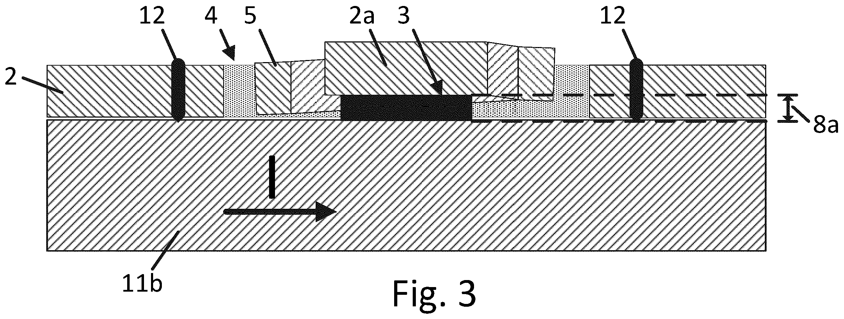

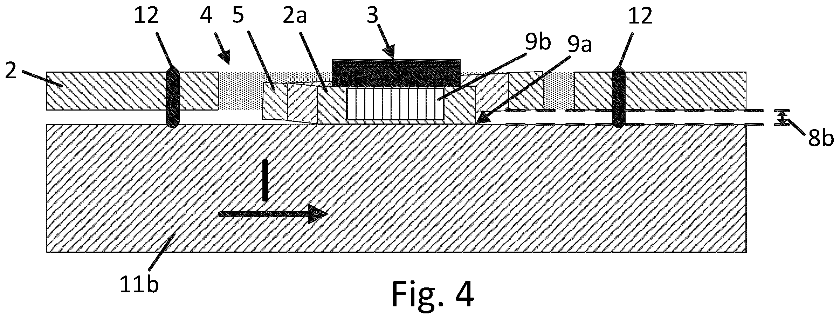

Die Stromermittlungsbaugruppe 10 weist eine Vorrichtung zur Temperaturmessung gemäß Fig. 1 mit einer Leiterplatte 2, einem Temperaturfühler 3 und einer um den Temperaturfühler 3 herum verlaufenden Ausfräsung 4 auf. Der Temperaturfühler 3 kann auf der dem Shunt 11 zugewandten Seite der Leiterplatte 2 angeordnet sein, d.h. zwischen der Leiterplatte 2 und der Oberfläche des Widerstandsbereichs 11b, vergleiche Fig. 3. Der Temperaturfühler 3 ist kann auch auf der dem Shunt 11 gegenüberliegenden Seite der Leiterplatte 2 angeordnet sein, d.h. auf derselben Seite wie die Auswerteeinheit 7, vergleiche Fig. 4. Zusätzlich weist die Stromermittlungsbaugruppe 10 zwei Spannungsabgriffe 12 auf, die entlang der Flussrichtung des Stroms I vor und hinter dem Temperaturfühler 3 angeordnet und elektrisch leitend mit der Oberfläche des Widerstandsbereichs 11b verbunden sind. Die Spannungsabgriffe 12 sind mit einem Spannungsmesser 13 verbunden, der eine Spannungsdifferenz zwischen den Potentialen auf der Oberfläche des Widerstandsbereichs 11b an den Positionen der Spannungsabgriffe 12 erfasst.

Eine hier nicht dargestellte Auswerteeinheit, die mit der Auswerteeinheit 7 kombiniert oder separat dazu ausgeführt sein kann, kann anhand des Ohm'schen Gesetzes aus den Messwerten des Spannungsmessers 13 und dem elektrischen Widerstand des Widerstandsbereichs 11b die Amplitude eines den Shunt 11 durchfließenden Stroms I ermitteln. Der elektrische Widerstand des Widerstandsbereichs 11b ist dabei in der Regel temperaturabhängig. Daher wird der bei der Ermittlung der Stromstärke rechnerisch verwendete elektrische Widerstand in Abhängigkeit von der vom Temperaturfühler 3 ermittelten Temperatur des Widerstandsbereichs 11b vorgegeben.

Der Widerstandsbereich 11b weist einen Querschnitt auf, der geringer ist als der Querschnitt der Anschlussbereiche 11a. Dadurch ist die Stromdichte eines den Shunt 11 durchfließenden Stroms I im Widerstandsbereich 11b erhöht. Da der Shunt 11 an sich auf möglichst geringe Verluste optimiert ist, ist eine Erhöhung der Stromdichte vorteilhaft, um eine Spannungsdifferenz zwischen den Spannungsabgriffen 12 zu erzeugen, die hoch genug ist, um sicher im Messbereich des Spannungsmessers 13 zu liegen. Alternativ oder zusätzlich zur Verjüngung des Querschnitts gemäß Fig. 2 kann der Widerstandsbereich 11b eine andere Materialzusammensetzung als die Anschlussbereiche 11a aufweisen, beispielsweise ein Material mit einem (leicht) erhöhten elektrischen Widerstand und/oder einer verringerten Temperaturabhängigkeit des elektrischen Widerstands.

**Fig. 3** zeigt einen Querschnitt durch die Vorrichtung zur Stromermittlung gemäß Fig. 2 in Höhe des Widerstandsbereichs 11b. Die Leiterplatte 2 liegt flächenbündig auf der Oberfläche des Shunt 11 auf. Der Temperaturfühler 3 ist auf der dem Shunt 11 zugewandten Seite der Leiterplatte 2 angeordnet, d.h. zwischen der Leiterplatte 2 und der Oberfläche des Widerstandsbereichs 11b, und liegt ebenfalls auf der Oberfläche des Widerstandsbereichs 11b auf. Dadurch hat sich der Temperaturfühler 3 gegenüber seiner Ruhelage im unmontierten Zustand der Leiterplatte 2 gegenüber der Ebene der Leiterplatte 2 um seine Bauhöhe 8a verschoben, indem das Leiterplattenplateau 2a um die Bauhöhe 8a parallel zum Normalenvektor der Ebene der Leiterplatte 2 versetzt ist. Dies ist möglich, da das Leiterplattenplateau 2a lediglich durch den verbleibenden Leiterplattensteg 5 mit dem Rest der Leiterplatte 2 verbunden ist. Der Versatz des Leiterplattenplateaus 2a um die Bauhöhe 8a verteilt sich somit auf eine elastische Verformung des gesamten Leiterplattenstegs 5 mit moderater Steigung gegenüber der Ebene der Leiterplatte 2.

Die elastische Verformung des Leiterplattenstegs 5 bewirkt eine Rückstellkraft, die den Temperaturfühler 3 auf die Oberfläche des Widerstandsbereichs 11b presst. Gleichzeitig werden die Spannungsabgriffe 12 durch die Leiterplatte 2 selbst auf die Oberfläche des Widerstandsbereichs 11b gepresst und damit in elektrischen Kontakt gebracht. Alternativ oder zusätzlich können die Spannungsabgriffe 12 auch selbst die mechanische Verbindung zwischen der Leiterplatte 2 und dem Shunt 11 herstellen, beispielsweise indem die Spannungsabgriffe 11 als Einpresskontakte ausgebildet sind, die in entsprechende Bohrungen in der Leiterplatte 2 und der Oberfläche des Shunt 11 eingepresst werden. Auch andere elektrische und/oder mechanische Kontaktierungen der Spannungsabgriffe 12 mit dem Widerstandsbereich 11b sind denkbar, beispielsweise über Federstifte, Schraub- oder Lötverbindungen oder ähnliches.

Der durch die Ausfräsung 4 ermöglichte Versatz des Leiterplattenplateaus 2a erlaubt insbesondere die flächenbündige Anordnung der Leiterplatte 2 am Widerstandsbereich 11b, obwohl der Temperaturfühler 3 zwischen der Leiterplatte 2 und der Oberfläche des Shunts 11 angeordnet ist. Dadurch können die zur Messung des Spannungsabfalls zwischen den Spannungsabgriffen 12 notwendigen elektrischen Verbindungen, insbesondere die Leitungen zwischen den Spannungsabgriffen 12 und dem Spannungsmesser 13, in unmittelbarer Nähe der Oberfläche des Widerstandsbereichs 11b verlaufen, und diesbezüglich unvorteilhafte, insbesondere senkrecht zur Oberfläche des Shunt 11 orientierte Leiterschleifen können weitgehend minimiert werden.

Fig. 4 zeigt einen Querschnitt durch eine weitere Ausführungsform der Vorrichtung zur Stromermittlung gemäß Fig. 2 in Höhe des Widerstandsbereichs 11b. Der Temperaturfühler 3 ist auf der dem Shunt 11 gegenüberliegenden Seite der Leiterplatte 2 angeordnet, d.h. auf derselben Seite wie die Auswerteeinheit 7. Das Leiterplattenplateau 2a, auf dem der Temperaturfühler 3 angeordnet ist, liegt auf der Oberfläche des Widerstandsbereichs 11b auf und ist mechanisch mit dem Shunt 11 verbunden, beispielsweise mittels eines Klebstoffs 9a, der als Wärmeleitklebstoff ausgeführt und auf hohe thermische Leitfähigkeit optimiert sein kann. Im Leiterplattenplateau 2a kann ein Wärmeleiter 9b angeordnet sein, beispielsweise ein Kupfer-Inlay oder mehrere zumindest teilweise miteinander verbundene Kupferlagen, wodurch die thermische Verbindung zwischen der Unterseite des Temperaturfühlers 3 und der dem Shunt 11 zugewandten Seite des Leiterplattenplateaus 2a verbessert wird.

Die Leiterplatte 2 kann einen gewissen Versatz 8b von der Oberfläche des Shunt 11 aufweisen. Dieser Versatz kann bewusst gewählt sein, beispielsweise aus konstruktiven Gründen. Ein Versatz der Ebene der Leiterplatte 2 von der Oberfläche des Shunt 11 kann zum Zeitpunkt der Fertigung auch minimiert sein, insbesondere indem die Leiterplatte flächig auf dem Shunt 11 aufliegt; nach der Montage kann jedoch insbesondere an der Stelle des Leiterplattenplateaus 2a ein zusätzlicher Versatz entstehen, z.B. wenn sich der Shunt 11 und/oder die Leiterplatte 2 verformen sollte. Eine an sich unerwünschte Verformung des Shunt 11 kann beispielsweise durch mechanische Krafteinwirkung während Montage oder Transport sowie durch im Betrieb auftretende thermische Ausdehnung und/oder elektromagnetische Kräfte entstehen, insbesondere wenn der Shunt 11 mittels der Verbindungselemente 14 in den Anschlussbereichen 11a mechanisch fixiert ist.

Durch die mechanische Verbindung des Leiterplattenplateaus 2a mit dem Shunt 11 wird der Temperaturfühler 3 parallel zum Normalenvektor der Ebene der Leiterplatte 2 verschoben, und zwar um denselben Betrag wie der konkrete Versatz zwischen der Leiterplatte 2 und der Oberfläche des Shunt 11 an der Stelle des Leiterplattenplateaus 2a. Dies ist möglich, da das Leiterplattenplateau 2a lediglich durch den verbleibenden Leiterplattensteg 5 mit dem Rest der Leiterplatte 2 verbunden ist. Der Versatz der Leiterplatte 2 gegenüber der Oberfläche des Shunt 11 verteilt sich dabei auf eine elastische Verformung des gesamten Leiterplattenstegs 5 mit moderater Steigung gegenüber der Ebene der Leiterplatte 2. Dabei erzeugt der Versatz eine Rückstellkraft zwischen dem fixierten Leiterplattenniveau 2a und der Leiterplatte 2, so dass die Leiterplatte 2 durch den Leiterplattensteg 5 zusätzlich zum Shunt 11 gezogen wird. Zusätzlich erlaubt der Leiterplattensteg 5 einen Ausgleich eines etwaigen lateralen Versatzes der Leiterplatte 2 gegenüber einer nominalen Einbauposition.

Die Spannungsabgriffe 12 sind in diesem Fall elektrisch und mechanisch mit dem Widerstandsbereich 11b verbunden, beispielsweise über Einpresskontakte, Federstifte, Schraub-, Steck- oder Lötverbindungen oder ähnliches.

Durch die Ausfräsung 4 wird somit ein Versatz der Leiterplatte 2 ermöglicht und gleichzeitig die thermische Verbindung zwischen Temperaturfühler 3 und Widerstandsbereich 11b gewährleistet. Dadurch kann eine gewisse Verformung des Shunt 11 im Betrieb toleriert werden. Alternativ oder zusätzlich können die Anforderungen an die Formstabilität des Shunts 11 in Abhängigkeit der thermischen und/oder mechanischen Randbedingungen reduziert werden, beispielsweise indem der Shunt 11 insgesamt dünner und entsprechend kostengünstiger ausgeführt werden kann.

In der Ausführungsform gemäß Fig. 4 ist die Unterseite des Temperaturfühlers 3 über das Leiterplattenplateau 2a thermisch mit dem Widerstandsbereich 11b des Shunt 11 verbunden. Dabei kann der Temperaturfühler 3 mittels einer Haube von der umgebenden Luft entkoppelt werden, so dass die Oberseite des Temperaturfühlers 3 durch einen etwaigen Luftstrom oberhalb der Leiterplatte 2 nicht beeinflusst wird, sondern weitgehend ausschließlich mit dem Widerstandbereich in thermischem Gleichgewicht steht. Dadurch wird die Messung der Temperatur des Widerstandsbereichs weiter verbessert.

### BEZUGSZEICHENLISTE

- 1: Temperaturmessbaugruppe
- 2: Leiterplatte
- 2a: Leiterplattenplateau
- 3: Temperaturfühler
- 4: Ausfräsung
- 5: Leiterplattensteg
- 6: Leiterbahnen
- 7: Auswerteeinheit
- 8a: Bauhöhe
- 8b: Versatz
- 9a: Klebstoff
- 9b: Wärmeleiter
- 10: Stromermittlungsbaugruppe
- 11: Shunt
- 11a: Anschlussbereich
- 11b: Widerstandsbereich
- 12: Spannungsabgriff
- 13: Spannungsmesser
- 14: Verbindungselemente

## Patentansprüche

1. Vorrichtung zur Stromermittlung mit einem Shunt (11), einer Leiterplatte (2), einer Auswerteeinheit (7) und einem Temperaturfühler (3), wobei der Shunt einen Widerstandsbereich (11b) mit einer im Wesentlichen ebenen Oberfläche aufweist, wobei die Vorrichtung zur Stromermittlung derart im Widerstandsbereich (11b) auf der Oberfläche des Shunt (11) angeordnet ist, dass der Temperaturfühler (3) in thermischer Verbindung mit dem Widerstandsbereich (11b) des Shunt (11) angeordnet ist, wobei Spannungsabgriffe (12) beiderseits des Temperaturfühlers (3) angeordnet sind und die Oberfläche des Shunt (11) elektrisch kontaktieren, um eine Potentialdifferenz entlang des Widerstandsbereichs (11b) zu erfassen, wobei die Leiterplatte (2) eine Ausfräsung (4) aufweist, die im Wesentlichen spiralförmig um den Temperaturfühler (3) verläuft, so dass der Temperaturfühler (3) auf einem Leiterplattenplateau (2a) angeordnet und durch einen zwischen den Windungen der spiralförmigen Ausfräsung (4) verbleibenden Leiterplattensteg (5) federnd gelagert ist, wobei der Temperaturfühler (3) parallel zum Normalenvektor der Ebene der Leiterplatte (2) verschiebbar ist und bei einer Verschiebung des Temperaturfühlers (3) gegenüber der Ebene der Leiterplatte (2) mittels des Leiterplattensteg (5) eine Rückstellkraft zwischen der Leiterplatte (2) und dem Temperaturfühler (3) wirkt.

2. Vorrichtung nach Anspruch 1, wobei die Leiterplatte (2) flächig auf dem Shunt (11) aufliegt, so dass die Spannungsabgriffe (12) elektrisch mit der Oberfläche des Shunt (11) kontaktiert sind und der Temperaturfühler (3) auf der Oberfläche des Shunt (11) aufliegt, wobei der Temperaturfühler (3) gegenüber der Ebene der Leiterplatte (2) um seine Bauhöhe (8a) verschoben ist, so dass der verbleibende Leiterplattensteg (5) eine Rückstellkraft auf das Leiterplattenplateau (2a) und damit eine Anpresskraft auf den Temperaturfühler (3) ausübt.

3. Vorrichtung nach Anspruch 1, wobei der Temperaturfühler (3) und die Auswerteeinheit (7) auf der dem Shunt (11) gegenüberliegenden Seite der Leiterplatte (2) angeordnet sind, wobei das Leiterplattenplateau (2a) mechanisch mit der Oberfläche des Shunt (11) verbunden ist, wobei das Leiterplattenplateau (2a) gegenüber der Ebene der Leiterplatte (2) verschiebbar ist und einen Versatz zwischen der Ebene der Leiterplatte (2) und der Oberfläche des Shunt (3) an der Stelle des Leiterplattenplateaus (2a) ausgleicht.

4. Vorrichtung nach Anspruch 3, wobei das Leiterplattenplateau (2a) einen Wärmeleiter (9b) zur Herstellung der thermischen Verbindung zwischen dem Temperatursensor (3) und dem Widerstandsbereich (11b) aufweist.

5. Vorrichtung nach einem der vorangehenden Ansprüche, wobei elektrische Leiterbahnen (6) zur Kontaktierung des Temperaturfühlers (3) mit der Auswerteeinheit (7) entlang des verbleibenden Leiterplattenstegs (5) verlaufen.

6. Vorrichtung nach einem der vorangehenden Ansprüche, wobei die Spannungsabgriffe (12) als Einpressstifte in der Leiterplatte (2), als Federkontakte, als Lötverbindungen oder als Schraubverbindungen mit dem Shunt (11) ausgeführt sind.

7. Vorrichtung nach einem der vorangehenden Ansprüche, wobei der Shunt (11) für die Durchleitung von Strömen ausgelegt ist, deren Amplitude mehr als 100 Ampere, bevorzugt mehr als 1000 Ampere beträgt.

8. Vorrichtung nach einem der vorangehenden Ansprüche, wobei der Shunt (11) zwei Anschlussbereiche (11a) aufweist, wobei der Widerstandsbereich (11b) zwischen den Anschlussbereichen (11a) angeordnet ist und im Wesentlichen durch eine Verjüngung des Querschnitts gegenüber dem Querschnitt der Anschlussbereiche (11a) des Shunt (11) gebildet wird.

9. Vorrichtung nach einem der Ansprüche 1 bis 7, wobei der Shunt (11) zwei Anschlussbereiche (11a) aufweist, wobei der Widerstandsbereich (11b) zwischen den Anschlussbereichen (11a) angeordnet ist und aus einem anderen Material als die Anschlussbereiche (11a) ausgeführt ist sowie optional eine Verjüngung des Querschnitts des Shunts (11) umfasst.

10. Vorrichtung nach einem der vorangehenden Ansprüche, wobei die Verjüngung eine Reduzierung des Querschnitts auf einen Wert zwischen 10 und 60 Prozent des Querschnitts der Anschlussbereiche (11a) des Shunt (11) umfasst.

11. Vorrichtung nach Anspruch 2, wobei zwischen dem Temperaturfühler (3) und der Oberfläche des Shunt (11) eine elektrisch isolierende Folie angeordnet ist.

12. Vorrichtung nach Anspruch 3 oder 4, wobei das Leiterplattenplateau (2a) mittels eines Klebstoffs (9a) mechanisch mit der Oberfläche des Shunt (11) verbunden ist

13. Leistungswandler mit stromführenden Leitungen zum Leiten der vom Leistungswandler verarbeiteten Gleich- und/oder Wechselströme, wobei mindestens eine der stromführenden Leitungen eine Vorrichtung zur Stromermittlung gemäß einem der Ansprüche 1 bis 12 aufweist, die eine Unterbrechung der stromführenden Leitungen überbrückt oder in die stromführenden Leitungen integriert ist, wobei der Leistungswandler dazu eingerichtet ist, aus einer mittels der Spannungsabgriffe (12) erfassten Potentialdifferenz entlang des Widerstandsbereichs (11b) des Shunt (11) und einem Widerstandswert des Widerstandsbereichs (11b) einen im Betrieb des Leistungswandlers durch die stromführenden Leitungen fließenden Strom zu ermitteln, wobei der Widerstandswert eine Funktion der vom Temperaturfühler (3) erfassten Temperatur ist.

14. Leistungswandler nach Anspruch 13, wobei der Leistungswandler auf eine Nennleistung ausgelegt ist, die größer als 10 kW, bevorzugt größer als 100 kW, besonders bevorzugt größer als 1000 kW ist.

## Claims

1. A device for determining current, with a shunt (11), a printed circuit board (2), an evaluation unit (7) and a temperature sensor (3), the shunt comprising a resistance region (11b) with a substantially planar surface, the device for determining current being arranged in the resistance region (11b) on the surface of the shunt (11) in such a way the temperature sensor (3) is arranged in thermal connection with the resistance region (11b) of the shunt (11), wherein voltage taps (12) are arranged on either side of the temperature sensor (3) and making electrical contact with the surface of the shunt (11) in order to detect a potential difference along the resistance region (11b), wherein the printed circuit board (2) comprises a milled-out section (4) which runs essentially in a spiral around the temperature sensor (3), such that the temperature sensor (3) is arranged on a printed circuit board plateau (2a) and is spring-mounted by a printed circuit board web (5) remaining between the turns of the spiral milled-out section (4), wherein the temperature sensor (3) is displaceable parallel to the normal vector of the plane of the printed circuit board (2) and a restoring force acts between the printed circuit board (2) and the temperature sensor (3) by means of the printed circuit board web (5) when the temperature sensor (3) is displaced relative to the plane of the printed circuit board (2).

2. The device according to claim 1, wherein the printed circuit board (2) rests flat on the shunt (11) such that the voltage taps (12) are in electrical contact with the surface of the shunt (11) and the temperature sensor (3) rests on the surface of the shunt (11), wherein the temperature sensor (3) is displaced relative to the plane of the printed circuit board (2) by its overall height (8a), such that the remaining printed circuit board web (5) exerts a restoring force on the printed circuit board plateau (2a) and thus a contact pressure on the temperature sensor (3).

3. The device according to claim 1, wherein the temperature sensor (3) and the evaluation unit (7) are arranged on the side of the printed circuit board (2) opposite the shunt (11), wherein the printed circuit board plateau (2a) is mechanically connected to the surface of the shunt (11), wherein the printed circuit board plateau (2a) is displaceable relative to the plane of the printed circuit board (2) and compensates for an offset between the plane of the printed circuit board (2) and the surface of the shunt (3) at the location of the printed circuit board plateau (2a).

4. The device according to claim 3, wherein the printed circuit board plateau (2a) comprises a heat conductor (9b) for producing the thermal connection between the temperature sensor (3) and the resistance region (11b).

5. The device according to one of the preceding claims, wherein electrical conductor tracks (6) for making contact between the temperature sensor (3) and the evaluation unit (7) run along the remaining printed circuit board web (5).

6. The device according to one of the preceding claims, wherein the voltage taps (12) are realized as press-fit pins in the printed circuit board (2), as spring contacts, as solder connections, or as screw connections with the shunt (11).

7. The device according to one of the preceding claims, wherein the shunt (11) is designed for conducting currents whose amplitude is more than 100 amperes, preferably more than 1000 amperes.

8. The device according to one of the preceding claims, wherein the shunt (11) has two terminal regions (11a), wherein the resistance region (11b) is arranged between the terminal regions (11a) and is essentially formed by a tapering of the cross section with respect to the cross section of the terminal regions (11a) of the shunt (11).

9. The device according to one of the claims 1 to 7, wherein the shunt (11) has two connection areas (11a), wherein the resistance area (11b) is arranged between the connection areas (11a) and is made of a different material than the connection areas (11a) and optionally comprises a tapering of the cross-section of the shunt (11).

10. The device according to one of the preceding claims, wherein the tapering comprises a reduction of the cross section to a value between 10 and 60 percent of the cross section of the connection areas (11a) of the shunt (11).

11. The device according to claim 2, wherein an electrically insulating film is arranged between the temperature sensor (3) and the surface of the shunt (11).

12. The device according to claim 3 or 4, wherein the printed circuit board plateau (2a) is mechanically connected to the surface of the shunt (11) by means of an adhesive (9a)

13. Power converter with current-carrying lines for conducting the direct currents and/or alternating currents processed by the power converter, wherein at least one of the current-carrying lines comprises a device for determining current in accordance with one of claims 1 to 12, which bridges an interruption in the current-carrying lines or is integrated into the current-carrying lines, wherein the power converter is configured to determine a current flowing through the current-carrying lines during operation of the power converter from a potential difference, detected by means of the voltage taps (12), along the resistance region (11b) of the shunt (11), and from a resistance value of the resistance region (11b), the resistance value being a function of the temperature detected by the temperature sensor (3).

14. The power converter according to claim 13, wherein the power converter is designed for a nominal power which is greater than 10 kW, preferably greater than 100 kW, particularly preferably greater than 1000 kW.

## Revendications

1. Dispositif de détermination de courant comprenant un shunt (11), une carte de circuit imprimé (2), une unité d'évaluation (7) et un capteur de température (3), le shunt présentant une zone de résistance (11b) avec une surface essentiellement plane, le dispositif de détermination de courant étant disposé dans la zone de résistance (11b) sur la surface du shunt (11) de telle sorte que le capteur de température (3) est disposé en liaison thermique avec la zone de résistance (11b) du shunt (11), des prises de tension (12) étant disposées de part et d'autre du capteur de température (3) et établissant un contact électrique avec la surface du shunt (11) afin de détecter une différence de potentiel le long de la zone de résistance (11b), la carte de circuit imprimé (2) présentant un fraisage (4) qui s'étend essentiellement en spirale autour de la sonde de température (3), de sorte que la sonde de température (3) est disposée sur un plateau de carte de circuit imprimé (2a) et est montée de manière élastique par une nervure de carte de circuit imprimé (5) restant entre les spires du fraisage en spirale (4), le capteur de température (3) pouvant être déplacé parallèlement au vecteur normal du plan de la carte de circuit imprimé (2) et une force de rappel agissant entre la carte de circuit imprimé (2) et le capteur de température (3) au moyen de la barrette de la carte de circuit imprimé (5) lors d'un déplacement du capteur de température (3) par rapport au plan de la carte de circuit imprimé (2).

2. Dispositif selon la revendication 1, dans lequel la carte de circuit imprimé (2) repose à plat sur le shunt (11), de sorte que les prises de tension (12) sont en contact électrique avec la surface du shunt (11) et que le capteur de température (3) repose sur la surface du shunt (11), le capteur de température (3) étant décalé par rapport au plan de la carte de circuit imprimé (2) de sa hauteur (8a), de sorte que la barrette de carte de circuit imprimé restante (5) exerce une force de rappel sur le plateau de carte de circuit imprimé (2a) et donc une force de pression sur le capteur de température (3).

3. Dispositif selon la revendication 1, dans lequel le capteur de température (3) et l'unité d'évaluation (7) sont disposés sur le côté de la carte de circuit imprimé (2) opposé au shunt (11), dans lequel le plateau de la carte de circuit imprimé (2a) est relié mécaniquement à la surface du shunt (11), le plateau de la carte de circuit imprimé (2a) pouvant être déplacé par rapport au plan de la carte de circuit imprimé (2) et compensant un décalage entre le plan de la carte de circuit imprimé (2) et la surface du shunt (3) à l'emplacement du plateau de la carte de circuit imprimé (2a).

4. Dispositif selon la revendication 3, dans lequel le plateau de la carte de circuit imprimé (2a) comporte un conducteur thermique (9b) pour établir la liaison thermique entre le capteur de température (3) et la zone de résistance (11b).

5. Dispositif selon l'une des revendications précédentes, dans lequel des pistes conductrices électriques (6) s'étendent le long de la barrette restante (5) de la carte de circuit imprimé pour établir le contact entre le capteur de température (3) et l'unité d'évaluation (7).

6. Dispositif selon l'une des revendications précédentes, dans lequel les prises de tension (12) sont réalisées sous forme de broches à enfoncer dans la carte de circuit imprimé (2), de contacts à ressort, de connexions soudées ou de connexions vissées avec le shunt (11).

7. Dispositif selon l'une des revendications précédentes, dans lequel le shunt (11) est conçu pour le passage de courants dont l'amplitude est supérieure à 100 ampères, de préférence supérieure à 1000 ampères.

8. Dispositif selon l'une des revendications précédentes, dans lequel le shunt (11) comporte deux zones de raccordement (11a), la zone de résistance (11b) étant disposée entre les zones de raccordement (11a) et étant formée essentiellement par un rétrécissement de la section transversale par rapport à la section transversale des zones de raccordement (11a) du shunt (11).

9. Dispositif selon l'une des revendications 1 à 7, dans lequel le shunt (11) présente deux zones de raccordement (11a), la zone de résistance (11b) étant disposée entre les zones de raccordement (11a) et étant réalisée dans un matériau différent de celui des zones de raccordement (11a) et comprenant en option un rétrécissement de la section transversale du shunt (11).

10. Dispositif selon l'une des revendications précédentes, dans lequel le rétrécissement comprend une réduction de la section transversale à une valeur comprise entre 10 et 60 % de la section transversale des zones de raccordement (11a) du shunt (11).

11. Dispositif selon la revendication 2, dans lequel une feuille électriquement isolante est disposée entre le capteur de température (3) et la surface du shunt (11).

12. Dispositif selon la revendication 3 ou 4, dans lequel le plateau de la carte de circuit imprimé (2a) est relié mécaniquement à la surface du shunt (11) au moyen d'un adhésif (9a).

13. Convertisseur de puissance avec des lignes conductrices pour conduire les courants continus et/ou alternatifs traités par le convertisseur de puissance, au moins une des lignes conductrices comportant un dispositif de détection de courant selon l'une des revendications 1 à 12, qui ponctue une interruption des lignes conductrices ou est intégré dans les lignes conductrices, le convertisseur de puissance étant conçu pour déterminer un courant circulant dans les lignes conductrices pendant le fonctionnement du convertisseur de puissance à partir d'une différence de potentiel détectée au moyen des prises de tension (12) le long de la zone de résistance (11b) du shunt (11) et d'une valeur de résistance de la zone de résistance (11b), la valeur de résistance étant fonction de la température détectée par le capteur de température (3).

14. Convertisseur de puissance selon la revendication 13, le convertisseur de puissance étant conçu pour une puissance nominale supérieure à 10 kW, de préférence supérieure à 100 kW, de préférence encore supérieure à 1000 kW.
